# EUROPEAN PATENT APPLICATION

(11) **EP 0 530 046 A1**
(43) Date of publication of application: **03.03.1993**
(21) Application number: 92307893.5
(22) Date of filing: 28.08.1992
(51) Int. Cl.: H01L 29/10, H01L 29/784

(54) **Integrated circuit transistor**

(30) Priority: 30.08.1991 US 752863
(71) Applicant: SGS-THOMSON MICROELECTRONICS, INC., Carrollton Texas 75006 (US)
(72) Inventor: Sandaresan, Ravishankar, Garland, Texas 75040, (US)
(74) Representative: Palmer, Roger

(57) **Abstract**

A method for fabricating an integrated circuit transistor begins with doping the substrate in the device active areas after field oxide regions have been formed. This dopant helps to reduce short channel transistor effects. A thin layer of epitaxial silicon is then grown over the substrate active regions. A field effect transistor is formed in the epitaxial layer and underlying substrate. The transistor channel region is in the relatively lightly doped epitaxial layer, but the underlying doped substrate layer helps minimize short channel effects.

## Description

The present invention relates generally to integrated circuit devices, and more specifically to a transistor suitable for use in integrated circuit devices having small feature sizes.

As semiconductor integrated circuit continue to become smaller, it becomes increasingly difficult to fabricate transistors which operate reliably and predictably. As device feature sizes shrink to dimensions well below one micron, transistors become strongly affected by short channel effects.

Short channel effects occur as a result of the voltage field at the drain. Since the channel is very short, the electric fields from both the gate and drain affect the flow of current through the channel, changing operation of the transistor from the desired parameters. If the drain electric field is strong enough, the depletion region can extend all the way to the source, resulting in purch through.

Short channel effects can mostly be negated by increasing the dopant concentration in the channel region. However, undesirable side effects occur as a result of increasing the dopant concentration. Carrier mobility is degraded, lowering transistor gain, and threshold voltage (Vₜ) are increased.

It would be desirable to provide a transistor structure, and method for making same, which provides improved avoidance of short channel effects without unduly adversely affecting transistor operating characteristics. It would be further desirable for such a structure and method to be compatible with widely available fabrication techniques.

Therefore, according to the present invention, a method for fabricating an integrated circuit transistor begins with doping the substrate in the device active areas after field oxide regions have been formed. This dopant helps to reduce short channel transistor effects. A thin layer of epitaxial silicon is then grown over the substrate active regions. A field effect transistor is formed in the epitaxial layer and underlying substrate. The transistor channel region is in the relatively lightly doped epitaxial layer, but the underlying doped substrate layer helps minimize short channel effects.

The novel features believed characteristic of the invention are set forth in the appended claims. The invention itself however, as well as a preferred mode of use, and further objects and advantages thereof, will best be understood by reference to the following detailed description of an illustrative embodiment when read in conjunction with the accompanying drawings, wherein:
**Figures 1 - 3** illustrate one preferred method for forming integrated circuit structures according to the present invention; and
**Figure 4** illustrates an alternative integrated circuit structure formed in accordance with the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

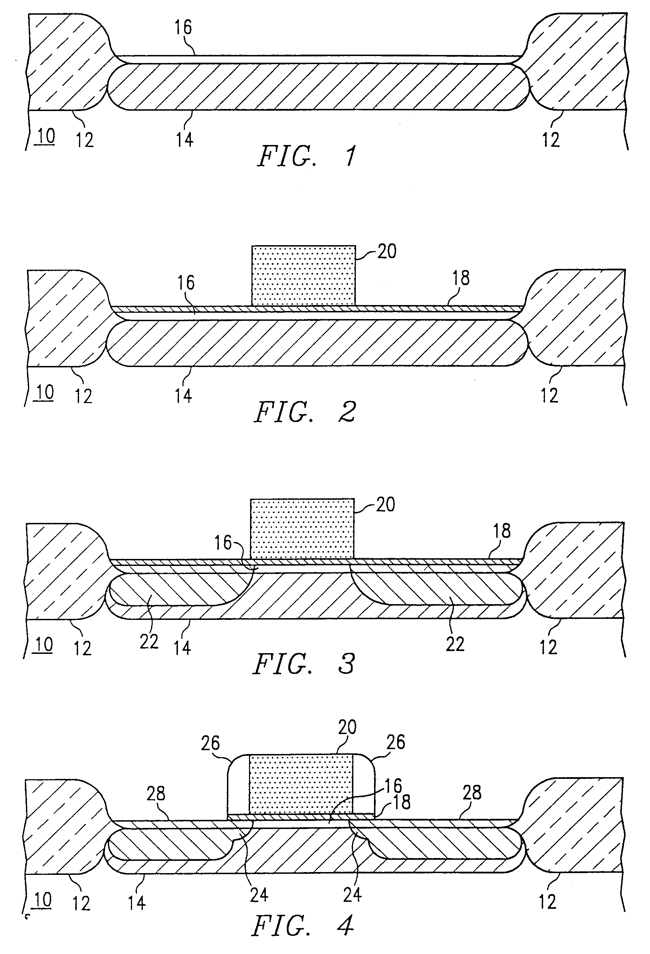

Referring to **Figure 1,** a substrate **10** is used for the formation of integrated circuit devices. Field oxide regions **12** are formed in the substrate **10** as known in the art. An upper surface region **14** of the substrate **10** is doped with a moderate amount of impurities.

The dopant concentration for region **14** is selected to be a moderate level which allows short channel effects to be controlled. If an n-channel transistor is to be formed, the region **14** can be doped with, for example, approximately 5 X 10¹⁷ atoms/cm³ of boron. The dopant in region **14** may be implanted or diffused into the substrate **10** as known in the art.

A thin epitaxial silicon region **16** is then grown on the substrate **10.** Epitaxial region **16** may be grown using molecular beam epitaxy (MBE) or a low temperature epitaxial growth process. Low temperature processes, less than approximately 850°C, are preferably used to minimize outdiffusion of dopant from the region **14.** Layer **16** is preferably grown to a thickness of approximately 500 - 1000 angstroms, and will contain the channel of the field effect transistor to be formed.

Referring to **Figure 2,** a thermal oxidation step is performed to convert a portion of the epitaxial layer **16** to gate oxide **18.** Gate oxide layer **18** is preferably less than approximately 150 angstroms thick. A polycrystalline silicon layer is then deposited over the entire device and patterned as known in the art to form a polycrystalline silicon gate electrode **20.** If desired, the polycrystalline silicon layer can be doped before patterning, and the polycrystalline silicon electrode **20** can be formed to include a refractory metal silicide to improve conductivity. Such techniques are well known in the art.

Referring to **Figure 3,** source drain regions **22** are formed in the substrate **10** and epitaxial layer **18** by implantation and anneal as known in the art. The source/drain region **22** junction extends into the moderately doped region **14.** The extension of this junction into the region **14** minimizes the short channel effect due to its higher dopant concentration. The channel of the transistor is formed in the epitaxial layer **16** beneath the gate electrode **20.** Since the epitaxial layer **16** is relatively lightly doped, the resulting transistor has good operating characteristics. If desired, prior to the formation of the polycrystalline silicon layer over the gate oxide layer **18,** a Vₜ adjust implant can be made into the epitaxial layer **16** in order to set the threshold voltage of the transistor to a desired value. Dopant outdiffusion from the moderately doped region **14** during epitaxial growth and later processing steps will also tend to vary the threshold voltage somewhat, and the Vₜ implant may not be necessary.

Referring to **Figure 4,** the technique of growing the additional epitaxial layer **16** can be used to form a self-aligned, lightly doped drain (LDD) structure. As known in the art, after patterning of the gate electrode **20,** an LDD implant is made to form lightly doped drain regions **24.** Sidewall oxide regions **26** are then formed along side the gate electrode **20** using an oxide deposition and anisotropic etch as known in the art, followed by implant of the heavily doped source/drain regions **28.** As before, the extension of the source/drain region junctions into the moderately doped region **14** reduces short channel effects, while the formation of the transistor channel in the lighter doped epitaxial layer **16** underneath a gate **20** produces a transistor having good operating characteristics.

As an alternative to growing the epitaxial layer **16** in **Figure 1,** a selective amorphous silicon deposition may be performed followed by a solid-phase epitaxial regrowth of the amorphous silicon. Such a regrowth step may be performed at approximately 550°C - 600°C as known in the art.

As will be appreciated by those skilled in the art, the technique described above results in a transistor which suffers minimal degradation from short channel effects, and has good operating characteristics due to the channel being formed in a relatively lightly doped epitaxial layer. Formation of the epitaxial layer **16** adds only minimal complexity to standard process flows, and allows high quality transistors to be fabricated using feature sizes of approximately one-half micron and less.

While the invention has been particularly shown and described with reference to a preferred embodiment, it will be understood by those skilled in the art that various changes in form and detail may be made therein without departing from the spirit and scope of the invention.

## Claims

1. A method for forming an integrated circuit device, comprising the steps of:
forming a region in a substrate which is doped with impurities;
forming a relatively thin layer of monocrystalline silicon over the substrate;
forming a gate insulating layer over the monocrystalline silicon layer;
forming a gate electrode over the gate insulating layer; and
forming source/drain regions in the monocrystalline silicon layer and in the substrate on either side of the gate electrode, leaving a channel region underneath the gate electrode in the monocrystalline silicon layer.

2. The method of Claim 1, wherein said step of forming a monocrystalline silicon layer comprises the step of:
growing a layer of epitaxial silicon on the substrate at a relatively low temperature.

3. The method of Claim 2, wherein said growing step comprises the step of:
growing the epitaxial silicon layer using molecular beam epitaxy.

4. The method of Claim 2, wherein said growing step comprises the step of:
growing the epitaxial silicon layer using low temperature epitaxy.

5. The method of Claim 1, wherein said step of forming a monocrystalline silicon layer comprises the steps of:
forming an amorphous silicon layer over the substrate; and
converting the amorphous silicon layer to monocrystalline silicon using solid-phase epitaxial regrowth.

6. The method of Claim 1, further comprising the steps of:
after said gate electrode forming step, implanting a light dose of impurities to form lightly doped drain regions; and
forming insulating sidewall regions alongside the gate electrode, wherein said step of forming source/drain regions forms heavily doped regions spaced away from under the gate electrode by approximately the width of the sidewall regions.

7. An integrated circuit device, comprising:
a substrate having a doped region therein;
a lighter doped monocrystalline silicon region overlying the substrate region;
a gate insulating layer and gate electrode overlying the monocrystalline silicon region, wherein a channel region is formed under the gate electrode; and
source/drain regions in said substrate and said monocrystalline silicon region adjacent the channel region.

8. The method of Claim 1 or the device of Claim 7, wherein said monocrystalline silicon comprises a layer of epitaxial silicon.

9. The device of Claim 8, wherein the channel region is lightly doped relative to the doped substrate region.

10. The device of Claim 7, further comprising:
sidewall insulating regions disposed alongside said gate electrode; and
lightly doped drain regions in said monocrystalline silicon region and said substrate underneath said sidewall insulating regions, wherein said source drain regions are spaced from the channel by said lightly doped drain regions.

11. The method of Claim 1 or device of Claim 7, wherein said gate insulating layer comprises oxide.

12. The method of Claim 11, wherein the oxide layer is thermally grown.

13. The device of Claim 7, wherein the doped substrate region has an impurity concentration of approximately 5 x 10¹⁷ atoms/cm³.

14. The device of Claim 7, wherein said gate electrode has a width less than approximately 0.5 micron.
